# EUROPEAN PATENT SPECIFICATION

(11) **EP 0 944 113 B1**
(45) Date of publication and mention of the grant of the patent: **09.11.2005**
(21) Application number: 98830095.0
(22) Date of filing: 24.02.1998
(51) Int. Cl.: H01L 29/06

(54) **Protection structure for high-voltage integrated electronic devices**
Schutzstruktur für integrierte elektronische Hochspannungsanordnungen
Structure de protection pour dispositifs électronique intégrés haute-tension

(43) Date of publication of application: 22.09.1999
(73) Proprietor: STMicroelectronics S.r.l., 20041 Agrate Brianza (Milano) (IT)
(72) Inventor: Legnani, Marco Alessandro, 21047 Saronno (IT); Pidutti, Albino, 33100 Udine (IT)
(74) Representative: Cerbaro, Elena

(56) References cited:
- EP-A- 0 588 067
- WO-A-94/16462
- PATENT ABSTRACTS OF JAPAN vol. 015, no. 269 (E-1087), 9 July 1991 -& JP 03 089554 A (NIPPON MINING CO LTD), 15 April 1991

## Description

The present invention relates to a protection structure for high-voltage integrated electronic devices.

As known, one of the main problems encountered in the production of high-voltage electronic devices is due to the establishment of high electrical fields on the surface of the device, which can cause premature breakdowns between high and low voltage regions (for example between sink and source terminal of high voltage MOS transistors), and instability of the electrical parameters of the device during its life, owing to charges outside the component (polarisation of the passivation, ionic contamination, polarisation of the resin of the package).

Various solutions have been proposed in order to reduce the surface electrical fields; among these, a technique which is widely used at present in the production of lateral devices uses a lightly doped layer (epitaxial layer optionally doped by implantation), which makes it possible to decrease considerably the surface electrical fields, and thus to obtain high breakdown voltages.

However this solution causes the device to be highly sensitive to charges which are localised outside the device, for example in the package resin, in the passivation oxide layers, and in the dielectric layers deposited at the end of the production process.

In addition, when the high voltage devices are to be connected to other components, it is problematic to connect the high voltage biased terminal using standard techniques (metallisation extending on the insulation surface), without inducing premature breakdowns.

Structures have thus been proposed, the purpose of which is to protect the device surface and to distribute the electrical potential as uniformly as possible over extensive areas, such as to reduce crowding of electrical field lines. In particular, use has been proposed of spiral-shaped resistive components, extending between high voltage regions and low voltage regions, such as to generate linear equal distribution of the potential, beginning from the centre to the periphery of the device (see for example US-A-5,349,232, EP-A-574,643, US-A-5,382,825, US-A-5,382,826 and the article "A 500V 1A 1-Chip Inverter IC with a New Electric Field Reduction Structure" by Koichi Endo, Yoshiro Baba, Yuso Udo, Mitsuru Yasui and Yoshiyuki Sano, Proc. of the 6th Internat. Symposium on Power Semiconductor Devices & ICs, Davos, Switzerland, May 31 - June 2, 1994). A variant in the use of resistive components includes the use of silicon junction diode chains (again see US-A-5,3,825 and US-A-5,349,232), or of a dielectric capacitor chain (see US-A-5,040,045).

Patent Abstracts of Japan col. 15 no. 269 (E-1087), 9 July 1991 and JP 03089554 disclose a protection structure including only two closed lines, the innermost and the outermost lines, connected by a spiral line, thus the distance between two facing points belonging to two adjacent lines is equal for practically all the extension of the intermediate portion.

EP-A-0 588 067 discloses another structure for protecting low voltage components integrated in circuits including also high voltage components.

The object of the invention is thus to provide a further protection structure which functions efficiently in preventing establishment of localised electrical fields inside the device, generated by external charges.

According to the present invention, a protection structure for high-voltage integrated electronic devices is provided, as defined in claim 1.

For better understanding of the present invention, some preferred embodiments are now described, purely by way of non-limiting example, with reference to the attached drawings, in which:
- figure 1 shows a top view of the protection structure according to the present invention;
- figure 2 shows a cross-section of an integrated device comprising the present protection structure; and
- figure 3 shows a cross-section of a different embodiment of the invention.

According to the invention, the protection structure comprises a plurality of protection regions of electrically conductive material, which extend along closed lines (for example circles or polygons) arranged one inside another, such as to be connected in series between an outermost protection region and an innermost protection region 2. In particular, the protection regions are of semiconductor material, and have reciprocal tangency areas offset from one another, such that the two areas in which an intermediate protection region contacts the two adjacent protection regions (one internally and the other externally), are different. In the case of protection regions shaped as circumferences, these tangency areas can be arranged diametrically to one another. In this case, in practice, there are two groups of circumferences; each group of circumferences comprises mutually concentric circumferences which are arranged eccentrically and alternately to the circumferences of the other group. The tangency areas may comprise two overlapping portions of the two adjacent protection regions, or two contiguous portions in electrical contact.

The protection structure can comprise resistive material, such as to form a resistive component, and thus have uniform characteristics over its entire area, or it can comprise doped portions which are alternately of P- and N-type, such as to form a plurality of diodes arranged in anti-series to each other.

In addition, the structure can comprise polycrystalline silicon extending above the surface of the substrate, or it can be integrated (implanted or diffused) inside the substrate itself. Optionally, it can comprise portions extending above the substrate and integrated portions, analogously to the solution disclosed in US-A-5,349,232.

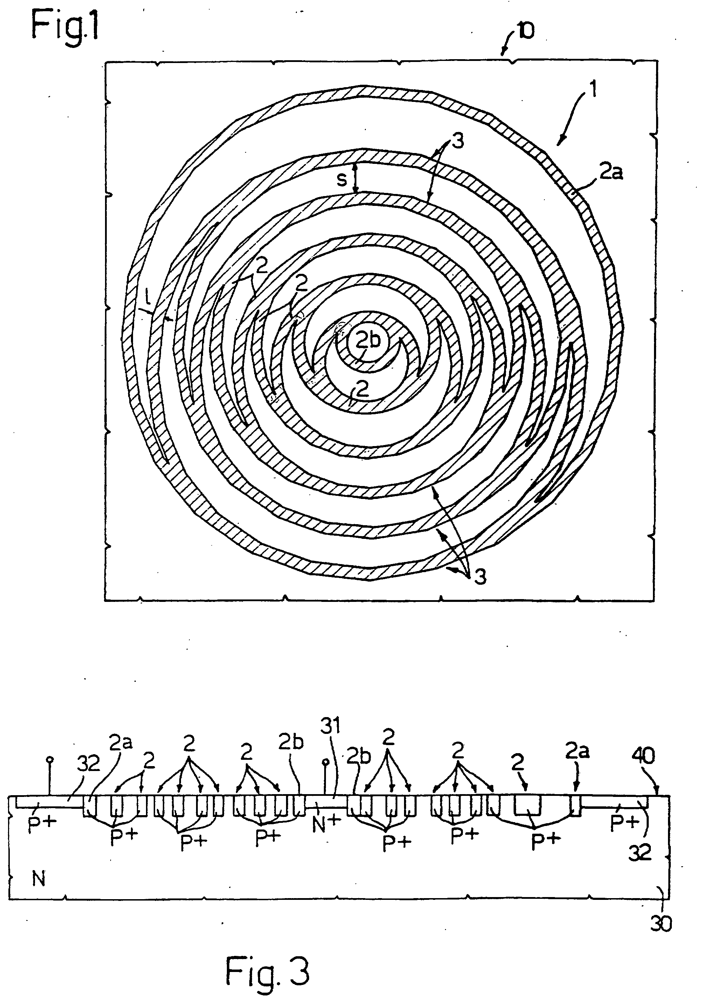

Figure 1 shows a top view of an embodiment of the present protection structure. In detail, as shown in figure 1, the structure 1 comprises a plurality of protection regions 2, which in this case have a polygonal shape with 24 sides, approximating a series of circumferences arranged one within another, and having a decreasing diameter, starting from the outermost protection region (indicated as 2a), towards the innermost protection region (indicated as 2b). The protection regions 2 overlap one another in areas, also known as tangency areas 3, which are offset from one another by approximately 180°, such that each protection region 2 is in contact with the internal and external protection regions adjacent to it, at diametrally opposed tangency areas 3.

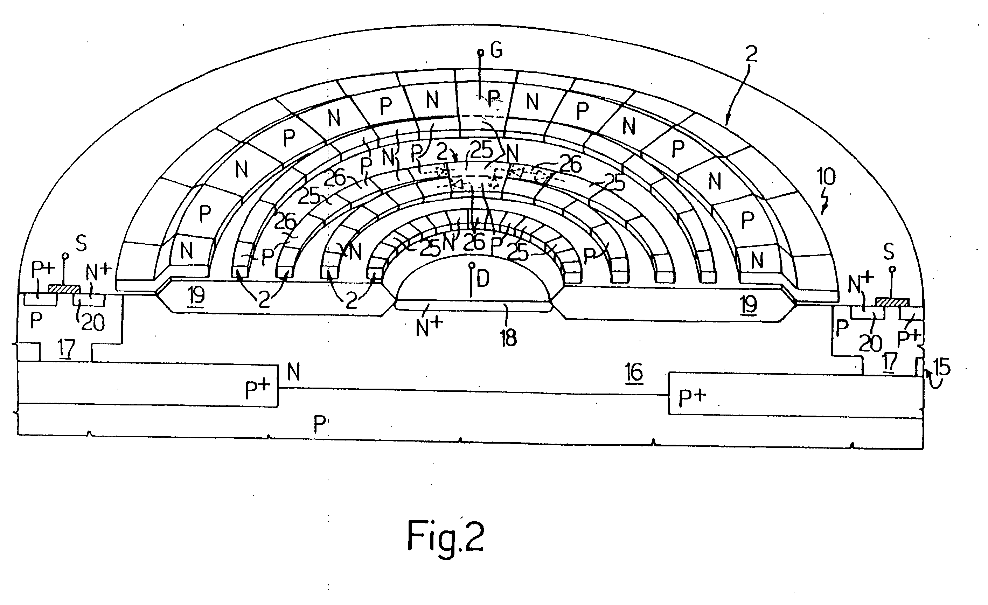

The extreme protection regions (outermost protection region 2a, and innermost protection region 2b) are disposed between different potential regions of a device 10 which must be protected against breakdown conditions; in particular, as will be described in greater detail hereinafter with reference to the embodiments of figures 2 and 3, the outermost protection region 2a is preferably arranged near, or adjacent to a low voltage protection region of the device 10, and the innermost protection region 2b is preferably arranged near or adjacent to a high voltage region.

Due to the above described arrangement, the distance between two adjacent protection regions 2 increases as the distance between the reciprocal tangency area increases, until the maximum value is reached at the area which is arranged diametrically, where the difference of potential between the two protection regions is maximal. Thereby, the electrical field on the device 10 is distributed uniformly, eliminating flow line crowding areas.

The protection regions 2 preferably have a width 1 which is as narrow as possible, the same for all the protection regions; similarly the maximum spacing s (measured in a diametral position with respect to the tangency area) is preferably as small as possible, and the same for all the protection regions 2, in as far as the limits imposed by the lithographic process allow, such as to obtain a maximum resistance value or a maximum number of diodes.

By virtue of the structure 1 of figure 1, the resistance contribution of each protection region 2 is the same as that of two half-circumferences in parallel, i.e. it is a quarter of the resistive value of each protection region. In the case of diodes on the other hand, two parallel chains of series-arranged diodes are obtained.

Figure 2 shows a cross-section through a lateral DMOS transistor, comprising the present protection structure 1. In detail, in figure 2, in a wafer 15 which comprises an epitaxial layer 16 of N-type, accommodating a body region 17 of P-type, a sink region 18 of N⁺-type is formed, surrounded by a thick oxide layer (field oxide 19), which extends between sink region 18 and body region 17. Inside body region 17 there is a source region 20 of N⁺-type. The protection structure 10 is formed on the surface of wafer 15, partly on the field oxide region 19 and partly on the free surface of epitaxial layer 16, electrically insulated from this surface by a not shown dielectric layer, is arranged between sink region 18 and source region 19, and forms a gate region of the DMOS transistor.

In the embodiment in figure 2, the protection regions 2 are doped such as to form portions alternately of N-type (portions 25) and of P-type (portions 26), such as to form a plurality of diodes (some of which are represented by broken lines), in anti-series. In addition, in the example shown, the protection regions 2 are disposed contiguously to one another at the tangency areas, without reciprocal overlapping (and therefore differently from the arrangement shown in figure 1).

In the embodiment in figure 3, the protection structure 10 is formed inside a substrate 30 of N-type having a surface 40, and comprises protection regions 2 of P⁺-type implanted or diffused in the substrate 30, and thus forming a resistive-type protection. In particular, the innermost protection region 2b externally delimits a first region 31 of N⁺-type for biasing the substrate 30 to a high voltage (e.g. 400 V). The outermost protection region 2a internally delimits a second region 32 of P⁺-type, which is set to a potential which is very different from that of the first region 31 (e.g. 0 V).

Thereby, the protection structure 1 ensures uniform potential distribution on the surface 40 of the substrate 30, between the potentials of first region 31 and second region 32.

The advantages of the described structure are as follows. Firstly, it allows uniform distribution of the potential near the surface of an electronic device, thus preventing dangerous crowding of the flow lines. In addition, when polysilicon is used on the substrate, the structure forms an electrostatic screen which is separated from the silicon structure of the component to be protected. Thereby, it is possible to produce metal connection lines and regions extending above the device areas which are interposed between the regions with different potential, without reducing the breakdown voltage of the device.

## Claims

1. A protection structure (1) for high-voltage integrated electronic devices (10), comprising a plurality of protection regions (2) of electrically conductive material, said protection regions (2) extending along closed lines arranged one inside another from an innermost to an outermost protection region (2b, 2a),
**characterised in that** said lines arranged one inside another from the innermost to the outermost protection region (2b, 2a) are connected at tangency areas (3), so that the distance between mutually facing portions of two adjacent protection regions (2) increases as the distance of said facing portions from the respective tangency area (3) increases.

2. A structure according to claim 1, **characterised in that** each said protection region (2) has a first tangency area (3) with a protection region (2) which is internally adjacent, and a second tangency area (3) with a protection region which is externally adjacent, the second tangency area being different from said first tangency area.

3. A structure according to claim 2, **characterised in that** said tangency areas (3) comprise partially overlapping portions between adjacent protection regions (2).

4. A structure according to claim 2 or claim 3, **characterised in that** said closed lines are circumferences.

5. A structure according to claim 4, **characterised in that** said first and second tangency areas (3) are diametrally opposed.

6. A structure according to claim 2 or 3, **characterised in that** said closed lines are polygons.

7. A structure according to any one of the preceding claims, **characterised in that** said protection regions (2) comprise resistive material forming a plurality of parallel arranged resistor pairs, said resistor pairs being disposed in series to each other.

8. A structure according to any one of claims 1-6, **characterised in that** said protection regions (2) comprise doped portions (25, 26) alternately of P- and N-type, and form a plurality of diodes in anti-series.

9. A structure according to any one of the preceding claims, **characterised in that** said protection regions (2) are made of polycrystalline silicon which extends on the surface of a substrate (16).

10. A structure according to any one of claims 1-8, **characterised in that** said protection regions (2) are formed in a substrate (30) of semiconductor material.

11. A structure according to any one of the preceding claims, **characterised in that** it extends between a first conductive region (18; 31) set to a first potential and a second conductive region (20; 32) set to a second potential which is different from said first potential.

12. A structure according to any one of the preceding claims, **characterised in that** said protection regions (2) have equal widths (1).

## Patentansprüche

1. Schutzstruktur (1) für integrierte elektronische Hochspannungsanordnungen (10), welche eine Vielzahl von Schutzbereichen (2) aus elektrisch leitendem Material aufweist, wobei sich die Schutzbereiche (2) entlang geschlossener Linien erstrecken, wobei diese, eine innerhalb einer anderen, von einem innersten zu einem äußersten Schutzbereich (2b, 2a) angeordnet sind,
**dadurch gekennzeichnet, dass** die Linien, wobei diese, eine innerhalb einer anderen, von dem innersten zu dem äußersten Schutzbereich (2b, 2a) angeordnet sind, an berührenden Flächen (3) verbunden sind, so dass sich der Abstand zwischen sich abwechselnd gegenüberliegenden Gebieten zweier angrenzender Schutzbereiche (2) so vergrößert, wie sich der Abstand der sich gegenüberliegenden Gebiete von der jeweiligen berührenden Fläche (3) vergrößert.

2. Struktur nach Anspruch 1, **dadurch gekennzeichnet, dass** jeder Schutzbereich (2) besitzt: eine erste berührende Fläche (3) mit einem Schutzbereich (2), welcher innen angrenzend ist, und einen zweiten berührenden Bereich (3) mit einem Schutzbereich, welcher außen angrenzend ist, wobei die zweite berührende Fläche unterschiedlich von der ersten berührenden Fläche ist.

3. Struktur nach Anspruch 2, **dadurch gekennzeichnet, dass** die berührenden Flächen (3) teilweise überlappende Gebiete zwischen angrenzenden Schutzbereichen (2) aufweisen.

4. Struktur nach Anspruch 2 oder 3, **dadurch gekennzeichnet, dass** die geschlossenen Linien Kreisumfangslinien sind.

5. Struktur nach Anspruch 4, **dadurch gekennzeichnet, dass** die ersten und zweiten berührenden Flächen (3) diametral gegenüber liegen.

6. Struktur nach Anspruch 2 oder 3, **dadurch gekennzeichnet, dass** die geschlossenen Linien Polygone sind.

7. Struktur nach einem der vorausgehenden Ansprüche, **dadurch gekennzeichnet, dass** die Schutzbereiche (2) Widerstandsmaterial aufweisen, welches eine Vielzahl von parallel angeordneten Widerstandspaaren bildet, wobei die Widerstandspaare in Reihe zueinander angeordnet sind.

8. Struktur nach einem der Ansprüche 1 - 6, **dadurch gekennzeichnet, dass** die Schutzbereiche (2) dotierte Gebiete (25, 26), abwechselnd vom P- und N-Typ, aufweisen, und eine Vielzahl von Dioden in gegenläufiger Reihe bilden.

9. Struktur nach einem der vorausgehenden Ansprüche, **dadurch gekennzeichnet, dass** die Schutzbereiche (2) aus polykristallinem Silizium hergestellt sind, welches sich über die Oberfläche des Substrates (16) erstreckt.

10. Struktur nach einem der Ansprüche 1 - 8, **dadurch gekennzeichnet, dass** die Schutzbereiche (2) in einem Substrat (30) aus Halbleitermaterial gebildet sind.

11. Struktur nach einem der vorausgehenden Ansprüche, **dadurch gekennzeichnet, dass** sie sich zwischen einem ersten leitenden Bereich (18; 31), welcher auf ein erstes Potential gesetzt ist, und einem zweiten leitenden Bereich (20; 32) erstreckt, welcher auf ein zweites Potential gesetzt ist, welches unterschiedlich zum ersten Potential ist.

12. Struktur nach einem der vorausgehenden Ansprüche, **dadurch gekennzeichnet, dass** die Schutzbereiche (2) gleiche Breite (1) besitzen.

## Revendications

1. Structure de protection (1) destinée à des dispositifs électroniques intégrés à haute tension (10), comprenant une pluralité de régions de protection (2) de matériau électriquement conducteur, lesdites régions de protection (2) s'étendant le long de lignes fermées agencées l'une dans l'autre depuis une région de protection la plus profonde jusqu'à une région de protection la plus éloignée (2b, 2a),
**caractérisée en ce que** lesdites lignes agencées l'une dans l'autre depuis la région de protection la plus profonde jusqu'à la région de protection la plus éloignée (2b, 2a) sont connectées en des zones de tangence (3), de sorte que la distance entre des parties mutuellement opposées de deux régions de protection adjacentes (2) augmente au fur et à mesure que la distance desdites parties opposées à partir de la zone de tangence respective (3) augmente.

2. Structure selon la revendication 1, **caractérisée en ce que** ce chaque dite région de protection (2) a une première zone de tangence (3) avec une région de protection (2) qui est adjacente intérieurement, et une seconde zone de tangence (3) avec une région de protection qui est adjacente extérieurement, la seconde zone de tangence étant différente de ladite première zone de tangence.

3. Structure selon la revendication 2, **caractérisée en ce que** lesdites zones de tangence (3) comprennent des parties partiellement chevauchantes entre des régions de protection adjacentes (2).

4. Structure selon la revendication 2 ou la revendication 3, **caractérisée en ce que** lesdites lignes fermées sont des circonférences.

5. Structure selon la revendication 4, **caractérisée en ce que** lesdites première et seconde zones de tangence (3) sont diamétralement opposées.

6. Structure selon la revendication 2 ou 3,
**caractérisée en ce que** lesdites lignes fermées sont des polygones.

7. Structure selon l'une quelconque des revendications précédentes, **caractérisée en ce que** lesdites régions de protection (2) comprennent un matériau résistif formant une pluralité de paires de résistances agencées en parallèle, lesdites paires de résistances étant disposées en série les unes par rapport aux autres.

8. Structure selon l'une quelconque des revendications 1 à 6, **caractérisée en ce que** lesdites régions de protection (2) comprennent des parties dopées (25, 26) tour à tour de type P et de type N, et forment une pluralité de diodes en anti-série.

9. Structure selon l'une quelconque des revendications précédentes, **caractérisée en ce que** lesdites régions de protection (2) sont faites de silicium polycristallin qui s'étend sur la surface d'un substrat (16).

10. Structure selon l'une quelconque des revendications 1 à 8, **caractérisée en ce que** lesdites régions de protection (2) sont formées dans un substrat (30) de matériau semi-conducteur.

11. Structure selon l'une quelconque des revendications précédentes, **caractérisée en ce qu'**elle s'étend entre une première région conductrice (18 ; 31) portée à un premier potentiel et une seconde région conductrice (20 ; 31) portée à un second potentiel qui est différent dudit premier potentiel.

12. Structure selon l'une quelconque des revendications précédentes, **caractérisée en ce que** lesdites régions de protection (2) ont des largeurs égales (1).
